# EUROPÄISCHE PATENTSCHRIFT

(11) **EP 0 304 951 B1**
(45) Veröffentlichungstag und Bekanntmachung des Hinweises auf die Patenterteilung: **16.06.1993**
(21) Anmeldenummer: 88113996.8
(22) Anmeldetag: 26.08.1988
(51) Int. Cl.: H03K 17/04

(54) **Optokoppler**
Optical coupler
Coupleur optique

(30) Priorität: 28.08.1987 DE 3728806
(43) Veröffentlichungstag der Anmeldung: 01.03.1989
(73) Patentinhaber: SIEMENS AKTIENGESELLSCHAFT, 80333 München (DE)
(72) Erfinder: Tihanyi, Jenö, Dr. Ing., D-8000 München 70 (DE); Weber, Roland, Dipl.-Ing., D-8000 München 40 (DE)

(56) Entgegenhaltungen:
- DE-A- 3 502 180
- US-A- 4 268 843
- PATENT ABSTRACTS OF JAPAN, Band 10, Nr. 58 (E-386)[2115], 7. März 1986; & JP-A-60 210 028 (HITACHI SEISAKUSHO K.K.) 22-10-1985
- PATENT ABSTRACTS OF JAPAN, Band 7, Nr. 40 (E-159)[1185], 17. Februar 1983; & JP-A-57 192 129 (TATEISHI DENKI K.K.) 26-11-1982

## Beschreibung

Die Erfindung bezieht sich auf einen Optokoppler mit mindestens einer LED und einer einzigen, mit der LED optisch gekoppelten Fotodiodenkette, mit zwei in Reihe geschalteten FET mit je einem ersten und einem zweiten Anschluß, deren Gateanschlüsse und erste Anschlüsse miteinander verbunden sind, wobei der erste Anschluß der Fotodiodenkette mit den Gateanschlüssen verbunden ist.

Ein solcher Optokoppler ist z. B. in der europäischen Patentanmeldung EP-A-0 048 146 beschrieben worden. Die Energie für die Ansteuerung der FET wird alleine aus der Fotodiodenkette gewonnen. Bei Belichtung über eine LED erzeugt die Fotodiodenkette eine Spannung, die den ersten der genannten FET leitend steuert. Der zweite FET ist bei Belichtung der Fotodiodenkette gesperrt. Ein Laststrom fließt dann durch den ersten FET und die integrierten Dioden des zweiten FET. Bei Aufhören der Belichtung wird der zweite FET leitend gesteuert und die erste FET gesperrt. Der Laststrom fließt dann durch den zweiten FET und durch die integrierte Diode des ersten FET.

Weitere Optokoppler mit einer Fotodiodenkette sind z. B. im Patent Abstract of Japan, Band 7, Nr. 40 (E-159) vom 17. Februar 1983 und in der DE-A 35 02 180 beschrieben worden. Der von den Fotodiodenketten gelieferte Strom beträgt im allgemeinen nur einige µA. Das heißt jedoch, daß der von der Fotodiodenkette angesteuerte FET nur langsam leitend gesteuert wird. Soll er schneller leitend gesteuert werden, so muß die Fotodiodenkette größer dimensioniert werden.

Ziel der Erfindung ist, einen Optokoppler der geschilderten Art derart weiterzubilden, daß schneller geschaltet werden kann bei kleinstmöglicher Dimensionierung der Fotodiodenkette.

Dieses Ziel wird erreicht durch die Merkmale:
a) der erste FET ist vom Anreicherungstyp und vom ersten Kanaltyp,
b) der zweite FET ist vom Anreicherungstyp und vom zweiten Kanaltyp,
c) der erste Anschluß der Fotodiodenkette ist über eine erste Diode mit dem zweiten Anschluß des ersten FET verbunden,
d) der zweite Anschluß der Fotodiodenkette ist mit dem zweiten Anschluß des zweiten FET verbunden,
e) die Diode ist derart gepolt, daß bei Belichtung der Fotodiodenkette ein Fotostrom durch den ersten FET fließen kann,
f) die ersten Anschlüsse der FET sind mit dem Gateanschluß eines Leistungs-FET verbunden,
g) der zweite Anschluß des zweiten FET ist mit dem Sourceanschluß des Leistungs-FET verbunden,
h) ein Kondensator ist über eine zweite Diode zwischen Sourceanschluß und Drainanschluß des Leistungstransistors angeschlossen, der mit der zweiten Diode (4) verbundene Anschluß des Kondensators (C) ist mit dem zweiten Anschluß (D) des ersten FET (5) verbunden,
i) die zweite Diode ist derart gepolt, daß der Kondensator aufgeladen wird, wenn der Leistungs-FET gesperrt ist,
k) der Fotostrom der Fotodiodenkette ist so groß wie der Verluststrom der Gate-Sourcekapazität des Leistungs-FET.

Weiterbildungen sind Gegenstand der abhängiges Ansprüche. Aus den Patent Abstracts of Japan, Band 10, Nr. 58 (E-386) vom 07. März 1986 ist es zwar bekannt, einen Leistungs-FET durch einen Kondensator schnell einzuschalten, der über eine Diode zwischen dem Drainanschluß und dem Sourceanschluß des Leistungs-FET angeschlossen ist. Dieser Kondensator wird durch einen FET entladen, der durch ein Eingangssignal leitend gesteuert werden kann. Diese Anordnung ist jedoch nur für den dynamischen Betrieb geeignet, da sich die Gate-Sourcekapazität des Leistungs-FET durch Verluste laufend entlädt und Ladestrom nicht nachgeliefert wird. Der Leistungs-FET sperrt daher nach kurzer Zeit. Im Gegensatz dazu ermöglicht die Erfindung auch eine statische Steuerung, da der Verluststrom der Gate-Sourcekapazität durch den Fotostrom kompensiert wird. Der Fotostrom braucht daher nur so groß zu sein, daß er die Verluste der Gate-Sourcekapazität ausgleicht.

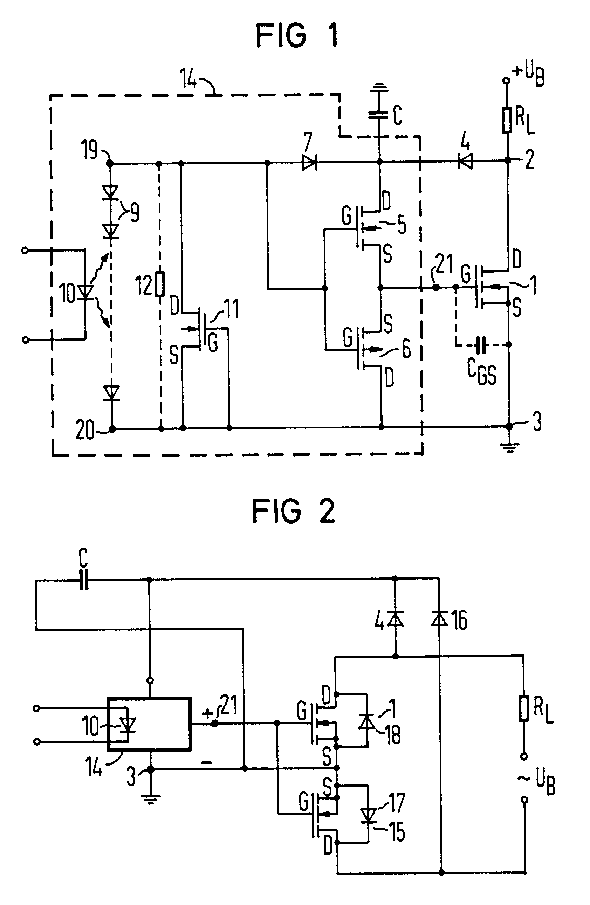

Die Erfindung wird anhand der Schaltungsdiagramme nach Figur 1 und 2 näher erläutert.

Der Optokoppler nach Figur 1 enthält einen Leistungs-FET 1. Sein Drainanschluß D ist mit einer Klemme 2, sein Sourceanschluß S mit einer Klemme 3 verbunden. Die Klemme 2 liegt über eine Last R_{L} an einer Betriebsspannungsquelle mit der Spannung +U_{B}. Die Klemme 3 liegt an negativer Spannung oder an Masse. Der Gateanschluß G ist mit den ersten Anschlüssen zweier FET's 5, 6 verbunden. Die ersten Anschlüsse sind hier die Sourceanschlüsse S, die elektrisch ebenfalls miteinander verbunden sind. Der FET 5 ist ein n-Kanal FET, der FET 6 ein p-Kanal FET. Beide sind vom Anreicherungstyp. Der zweite Anschluß des FET 5, in diesem Fall der Drainanschluß, ist über eine Diode 7 mit dem ersten Anschluß 19 einer Fotodiodenkette verbunden. Im Ausführungsbeispiel ist dies der Anodenanschluß. Der zweite Anschluß des FET 6, in diesem Fall der Drainanschluß D, ist mit der zweiten Klemme 3 und mit dem zweiten Anschluß 20 der Fotodiodenkette 9 verbunden.

Der Anschluß 20 ist hier der Katodenanschluß der Fotodiodenkette. Die Gateanschlüsse G der FET 5 und 6 sind miteinander und dem ersten Anschluß 19 der Fotodiodenkette 9 verbunden. Die Fotodiodenkette 9 ist optisch mit einer LED 10 gekoppelt.

Der zweite Anschluß D des ersten FET 5 ist mit einem Anschluß eines Kondensators C verbunden. Sein anderer Anschluß liegt z. B. an Masse oder an negativem Potential. Zwischen dem Drainanschluß D des FET 1 und dem zweiten Anschluß D des FET 5 liegt eine Diode 4. Diese ist so gepolt, daß der Kondensator C über den Lastwiderstand R_{L} positiv aufgeladen werden kann. Die Diode 7 ist derart gepolt, daß bei Belichtung der Fotodiodenkette 9 ein Fotostrom durch den FET 5 fließen kann.

Zwischen den Gateanschlüssen G und dem zweiten Anschluß D des FET 6 liegt die Laststrecke eines FET 11. Dieser ist ein n-Kanal-FET vom Verarmungstyp. Hierbei ist der Sourceanschluß S mit dem Gateanschluß G verbunden. Beide liegen am zweiten Anschluß des FET 6 bzw. an der Klemme 3 bzw. am zweiten Anschluß 20 der Fotodiodenkette 9. Der FET 11 kann auch durch einen Widerstand 12 ersetzt werden, dessen Zuleitungen gestrichelt gezeichnet sind.

Wird die Fotodiodenkette 9 belichtet, so fließt ein Strom von Anschluß 19 in den Gateanschluß der FET 5 und 6. Der FET 5 wird leitend gesteuert und der FET 6 gesperrt. Der leitende FET 5 entlädt den Kondensator C, dessen Entladestrom in die Gate-Source-Kapazität C_{GS} des FET 1 fließt. Die Kapazität des Kondensators C ist derart bemessen, daß die gespeicherte Ladung die C_{GS} des FET 1 schnell auflädt. Sie beträgt z. B. 10 nF. Der a Leistungs-FET 1 wird jetzt leitend gesteuert und der Laststrom kann durch die Last R_{L} fließen.

Der FET 5 und der Leistungs-FET 1 bleibt solang leitend, wie die Fotodiodenkette 9 belichtet wird. Dabei fließt ein Fotostrom durch die Diode 7 und den FET 5 in C_{GS} des FET 1 und hält diesen geladen. Der Fotostrom braucht dabei nur so groß wie der Verluststrom von C_{GS} zu sein.

Hört die Belichtung auf, so kann sich die Gate-Sourcekapazität des FET 5 über den FET 11 bzw. den Widerstand 12 entladen und der FET 5 sperrt. Gleichzeitig wird der zweite FET 6 leitend gesteuert, wodurch sich die C_{GS} des Leistungs-FET 1 entlädt und dieser sperrt.

Bei der angegebenen Polarität der Spannungen ist der Leistungs-FET 1 ein n-Kanal-FET. Bei anderer Polarität der Spannung sind FET des jeweils komplementären Kanaltyps einzusetzen. Handelt es sich bei den FET 5 und 6 um Lateral-FET, können beispielsweise auch die Drainanschlüsse D miteinander und die Sourceanschlüsse S mit dem Kondensator C bzw. der Klemme 3 verbunden werden. Die Spannung an beiden Anschlüssen unterscheidet sich in leitendem Zustand maximal um die Einsatzspannung des jeweiligen FET.

Für eine optimale Funktion der Schaltung empfielt es sich, die Schaltung so zu dimensionieren, daß die Fotospannung abzüglich der Durchlaßspannung der Diode 7 abzüglich der Einsatzspannung des FET 5 größer ist als die Einsatzspannung des FET 1. Die absolute Einsatzspannung des FET 6 muß dafür kleiner sein als die absolute Einsatzspannung des Leistungs-FET 1. Der FET 11 ist derart dimensioniert, daß sein Strom wesentlich kleiner als der Fotostrom ist, z. B. 1µA.

Der Optokoppler nach Figur 1 ist für den Betrieb an einer Gleichspannung einsetzbar. Ein Optokoppler für Wechselspannung ist in Figur 2 dargestellt. Dabei sind gleiche oder funktionsgleiche Teile mit gleichen Bezugszeichen wie in Figur 1 versehen. Der Optokoppler nach Figur 2 hat einen zweiten Leistungs-FET 15. Der Sourceanschluß des FET 15 ist mit dem Sourceanschluß S des FET 1 verbunden. Der Drainanschluß D von 15 liegt an einer Klemme einer Wechselspannung, während der Drainanschluß von D über die Last R_{L} an der anderen Klemme dieser Wechselspannungsquelle liegt. Die Sourceanschlüsse S liegen gemeinsam an der Klemme 3, d. h. an Masse. Die Gateanschlüsse G sind miteinander und mit einer Klemme 21 der Ansteuerschaltung 14 verbunden. Diese ist in Figur 1 von der gestrichelten Linie umfaßt. Der Kondensator C wird während einer ersten Halbwelle durch die Diode 4 und in der anderen Halbwelle durch eine Diode 16 aufgeladen, die mit dem Drainanschluß des Leistungs-FET 15 verbunden ist. Für die Funktion ist wesentlich, daß beide Leistungs-FET 1, 15 eine integrierte Diode 18 bzw. 17 enthalten, deren Anodenzone durch die Sourcezone und deren Kathodenzone durch die Drainzone des jeweiligen Leistungs-FET gebildet ist. Diese Dioden sind Bestandteil eines jeden Leistungs-FET.

Bei Belichtung der Fotodiodenkette in der Ansteuerschaltung 14 erscheint an der Klemme 21 positives Potential und der Kondensator C kann sich in die Gate-Sourcekapazität des FET 1 entladen. Dieser wird damit sehr schnell aufgesteuert und es fließt ein Strom durch die Last R_{L}, durch den FET 1 und durch die Diode 17 des FET 15 zur anderen Klemme der Wechselspannungsquelle. Während der zweiten Halbwelle fließt der Strom durch den FET 15 und die Diode 18 des FET 1 in die Last R_{L}. Bei Aufhören der Belichtung werden beide Leistungs-FET über den FET 6 der Ansteuerschaltung 14 gesperrt.

Die Ansteuerschaltung 14 kann integriert in der Technik der dielektrischen Isolation ausgeführt werden, wie z. B. in der EP-A-0 048 146 beschrieben.

## Patentansprüche

1. Optokoppler mit mindestens einer LED und einer einzigen, mit der LED optisch gekoppelten Fotodiodenkette, mit zwei in Reihe geschalteten FET mit je einem ersten und einem zweiten Anschluß, deren Gateanschlüsse und erste Anschlüsse miteinander verbunden sind, wobei der erste Anschluß der Fotodiodenkette mit den Gateanschlüssen verbunden ist, **gekennzeichnet durch** die Merkmale:
a) der erste FET (5) ist vom Anreicherungstyp und vom ersten Kanaltyp,
b) der zweite FET (6) ist vom Anreicherungstyp und vom zweiten Kanaltyp,
c) der erste Anschluß (19) der Fotodiodenkette (9) ist über eine erste Diode (7) mit dem zweiten Anschluß (D) des ersten FET (5) verbunden,
d) der zweite Anschluß (20) der Fotodiodenkette ist mit dem zweiten Anschluß (D) des zweiten FET (6) verbunden,
e) die Diode (7) ist derart gepolt, daß bei Belichtung der Fotodiodenkette ein Fotostrom durch den ersten FET fließen kann,
f) die ersten Anschlüsse (S) der FET sind mit dem Gateanschluß (G) eines Leistungs-FET (1) verbunden,
g) der zweite Anschluß (D) des zweiten FET (6) ist mit dem Sourceanschluß (S) des Leistungs-FET (1) verbunden,
h) ein Kondensator (C) ist über eine zweite Diode (4) zwischen Sourceanschluß und Drainanschluß des Leistungstransistors angeschlossen, der mit der zweiten Diode (4) verbundene Anschluß des Kondensators (C) ist mit dem zweiten Anschluß (D) des ersten FET (5) verbunden,
i) die zweite Diode (4) ist derart gepolt, daß der Kondensator (C) aufgeladen wird, wenn der Leistungs-FET (1) gesperrt ist,
k) der Fotostrom der Fotodiodenkette (9) ist so groß wie der Verluststrom der Gate-Sourcekapazität (C_{GS}) des Leistungs-FET (1).

2. Optokoppler nach Anspruch 1,
**dadurch gekennzeichnet,**
daß der Kondensator (C) über einen Widerstand (R_{L}) aus der Betriebsspannungsquelle (+U_{B}) für den Leistung-FET aufgeladen wird.

3. Optokoppler nach Anspruch 1,
**dadurch gekennzeichnet,**
daß zwischen den Gateanschlüssen (G) der FET (5, 6) und dem zweiten Anschluß (D) des zweiten FET (6) ein Widerstand (12) liegt.

4. Optokoppler nach Anspruch 1,
**dadurch gekennzeichnet,**
daß zwischen den Gateanschlüssen der FET (5, 6) und dem zweiten Anschluß des zweiten FET (6) ein FET (11) vom Verarmungstyp liegt, dessen Gateanschluß (G) und Sourceanschluß (S) mit dem zweiten Anschluß (D) des zweiten FET (6) verbunden ist.

## Claims

1. Optocoupler having at least one LED and a single photodiode chain, optically coupled with the LED, and two series-connected FETs, each having a first terminal and a second terminal, the gate terminals and first terminals of which are connected to each other, the first terminal of the photodiode chain being connected to the gate terminals, characterised by the features:
a) the first FET (5) is of the enhancement type and of the first channel type,
b) the second FET (6) is of the enhancement type and of the second channel type,
c) the first terminal (19) of the photodiode chain (9) is connected via a first diode (7) to the second terminal (D) of the first FET (5),
d) the second terminal (20) of the photodiode chain is connected to the second terminal (D) of the second FET (6),
e) the diode (7) is poled in such a way that, upon illumination of the photodiode chain, a photocurrent can flow through the first FET,
f) the first terminals (S) of the FETs are connected to the gate terminal (G) of a power FET (1),
g) the second terminal (D) of the second FET (6) is connected to the source terminal (S) of the power FET (1),
h) a capacitor (C) is connected via a second diode (4) between source terminal and drain terminal of the power transistor, the terminal of the capacitor (C) which is connected to the second diode (4) is connected to the second terminal (D) of the first FET (5),
i) the second diode (4) is poled in such a way that the capacitor (C) is charged when the power FET (1) is blocked,
k) the photocurrent of the photodiode chain (9) is as great as the leakage current of the gate-source capacitance (C_{GS}) of the power FET (1).

2. Optocoupler according to Claim 1, characterised in that the capacitor (C) is charged via a resistor (R_{L}) from the operating voltage source (+U_{B}) for the power FET.

3. Optocoupler according to Claim 1, characterised in that a resistor (12) lies between the gate terminals (G) of the FETs (5, 6) and the second terminal (D) of the second FET (6).

4. Optocoupler according to Claim 1, characterised in that an FET (11) of the depletion type lies between the gate terminals of the FETs (5, 6) and the second terminal of the second FET (6), the gate terminal (G) and source terminal (S) of which FET of the depletion type are connected to the second terminal (D) of the second FET (6).

## Revendications

1. Optocoupleur comportant au moins une diode LED et une seule chaîne de photodiodes couplée optiquement à la diode LED, deux transistors FET branchés en série et comportant chacun une première borne et une seconde borne et dont les bornes de grille et les premières bornes sont raccordées entre elles, la première borne de la chaîne de photodiodes étant raccordée aux bornes de grille, caractérisé par les particularités suivantes :
a) le premier transistor FET (5) est du type à enrichissement et possède un canal d'un premier type,
b) le second transistor FET (6) est du type à enrichissement et possède un canal d'un second type,
c) la première borne (19) de la chaîne de photodiodes (9) est raccordée par l'intermédiaire d'une première diode (7) à la seconde borne (D) du transistor FET (5),
d) la seconde borne (20) de la chaîne de photodiodes est raccordée à la seconde borne (D) du second transistor FET (6),
e) la diode (7) est polarisée de telle sorte que lors de l'éclairement de la chaîne de photodiodes, un courant photoélectrique peut traverser le premier transistor FET,
f) les premières bornes (S) des transistors FET sont raccordées à la grille (G) d'un transistor FET de puissance (1),
g) la seconde borne (D) du second transistor FET (6) est raccordée à la borne de source (S) du transistor FET de puissance (1),
h) un condensateur (C) est raccordé par l'intermédiaire d'une seconde diode (4) entre la borne de source et la borne de drain du transistor de puissance, la borne du condensateur (C) raccordée à la seconde diode (4), étant raccordée à la seconde borne (D) du troisième transistor FET (5),
i) la seconde diode (4) est polarisée de telle sorte que le condensateur (C) est chargé lorsque le transistor FET de puissance (1) est bloqué,
k) le courant photoélectrique de la chaîne de photodiodes (9) possède une intensité égale à celle du courant de perte de la capacité grille-source (G_{CS}) du transistor FET de puissance (1).

2. Optocoupleur suivant la revendication 1, caractérisé par le fait que le condensateur (C) est chargé par l'intermédiaire d'une résistance (R_{L}), à partir de la source de tension de service (+U_{B}) pour le transistor FET de puissance.

3. Optocoupleur suivant la revendication 1, caractérisé par le fait qu'une résistance (12) est branchée entre les bornes de grille (G) des transistors FET (5,6) et la seconde borne (D) du second transistor FET (6).

4. Optocoupleur suivant la revendication 1, caractérisé par le fait qu'entre les bornes de grille des transistors FET (5,6) et la seconde borne du second transistor FET (6) est branché un transistor FET (11) du type à appauvrissement, dont la borne de grille (G) et la borne de source (S) sont raccordées à la seconde borne (D) du second transistor FET (6).
